# EUROPÄISCHE PATENTSCHRIFT

(11) **EP 4 090 145 B1**
(45) Veröffentlichungstag und Bekanntmachung des Hinweises auf die Patenterteilung: **15.04.2026**
(21) Anmeldenummer: 22172755.5
(22) Anmeldetag: 11.05.2022
(51) Int. Cl.: H10W 40/47, H05K 7/20, H10W 40/43, H10W 40/60, H10W 40/77

(54) **KÜHLEINRICHTUNG ZUM ABFÜHREN VON WÄRME**
COOLING DEVICE FOR DISSIPATING HEAT
DISPOSITIF DE REFROIDISSEMENT PERMETTANT D'ÉLIMINER LA CHALEUR

(30) Priorität: 12.05.2021 DE 102021112415
(43) Veröffentlichungstag der Anmeldung: 16.11.2022
(73) Patentinhaber: Erwin Quarder Systemtechnik GmbH, 32339 Espelkamp (DE)
(72) Erfinder: Siewert, Georg, 35415 Pohlheim (DE); Heitbrink, Alexander, 32351 Stemwede (DE); Bruns, Stefan, 49088 Osnabrück (DE)
(74) Vertreter: Geskes, Christoph

(56) Entgegenhaltungen:
- EP-A2- 0 320 198
- DE-B3- 102004 012 026
- DE-T5- 112019 001 566
- JP-A- S6 381 959
- US-A- 5 150 274
- US-A- 6 111 749
- US-A1- 2012 080 785
- US-A1- 2019 301 809
- US-A1- 2020 337 181

## Beschreibung

Die vorliegende Erfindung betrifft eine Kühleinrichtung zum Abführen von Wärme von zu kühlenden Gegenständen, wie etwa Leistungselektronikbauteilen, mit mindestens einem vorzugsweise starren, insbesondere massiven Kühlkörper, bevorzugt aus Metall, insbesondere aus Aluminium, zur Aufnahme von Wärme eines oder mehrerer zu kühlender Gegenstände, und mit einem Kühlfluidraum zur Aufnahme von Kühlfluid, insbesondere Kühlflüssigkeit, an die Wärme des Kühlkörpers weiterleitbar ist.

Bei Kühleinrichtungen mit einem Kühlkörper mit einer ebenen bzw. planen Wärmeaufnahmeseite, die im Einsatz der Kühleinrichtung zur Optimierung der Wärmeübertragung möglichst nah - ggf. unter direkter Anlage oder unter Vermittlung einer Zwischenschicht aus Wärmeleitmaterial, insbesondere Wärmeleitpaste - an einer (beispielsweise ebenfalls planen) Wärmeabgabeseite des zu kühlenden Gegenstands angeordnet werden sollte, ergibt sich häufig die Situation, dass entweder der Kühlkörper bzw. dessen ebene Wärmeaufnahmeseite gleichzeitig an mehreren zu kühlenden Gegenständen angeordnet werden muss, deren Wärmeabgabeseiten aufgrund jeweils unterschiedlicher Höhenabmessung der Gegenstände in unterschiedlichen Ebenen verlaufen, oder dass der Kühlkörper bzw. dessen Wärmeaufnahmeseite an eine nicht durchgängig eben verlaufende Wärmeabgabeseite eines einzelnen zu kühlenden Gegenstands angeordnet werden muss.

In beiden Fällen können sich bereichsweise größere, für eine effiziente Wärmeübertragung ungünstige Abstände ergeben zwischen der bzw. den Wärmeabgabeseiten des bzw. der zu kühlenden Gegenstände einerseits und der ebenen Wärmeaufnahmeseite des Kühlkörpers andererseits, was sich zu Lasten der Kühlleistung der Kühleinrichtung auswirkt.

Aus diesem Grund werden zum Teil Wärmeleitpasten vergleichsweiser großer Schichtdicken eingesetzt, um die entsprechenden, andernfalls nur durch schlecht wärmeleitende Luft gefüllten Abstände zu überbrücken. Diese Lösung ist allerdings nicht optimal. Unter anderem deshalb, da die verwendbaren Wärmeleitpasten in der Regel eine geringere Wärmeleitfähigkeit aufweisen als das Metall des Kühlkörpers. US 2019/0301809 A1 offenbart eine Baugruppe zur Übertragung von Wärme in Bezug auf eine oder mehrere Komponenten, z. B. zur Kühlung von Leistungselektronik, Computerprozessoren und anderen Geräten. Die Bauteile können mit Wärmeübertragungsflächen in Berührung kommen, die durch eine Wärmeübertragungsflüssigkeit erhitzt oder gekühlt werden. Die Wärmeübertragungsflächen können von einem Verbindungsteil getragen werden, das es ermöglicht, die Wärmeübertragungsflächen relativ zueinander bewegt werden können. US 2020/0337181 A1 offenbart eine Vorrichtung umfassend eine obere Wand und eine untere Wand. Die obere Wand und die untere Wand definieren und umschließen einen ersten Rippenbereich, einen zweiten Rippenbereich und einen Biegebereich, der den ersten Rippenbereich mit dem zweiten Rippenbereich verbindet. Der Biegebereich steht in Fluidverbindung mit dem Inneren des ersten Rippenbereichs und dem Inneren des zweiten Rippenbereichs verbunden.

Ausgehend hiervon ist es Aufgabe der vorliegenden Erfindung, eine Kühleinrichtung der eingangs genannten Art weiterzuentwickeln.

Diese Aufgabe wird gelöst durch eine Kühleinrichtung mit den Merkmalen des Anspruchs 1.

Eine erfindungsgemäße Kühleinrichtung der eingangs genannten Art ist dementsprechend dadurch gekennzeichnet, dass die Kühleinrichtung ein unteres Kühlbauteil mit einem unteren Kühlkörper und ein oberes Kühlbauteil mit mindestens zwei vorzugsweise starren, insbesondere aus massivem Material bestehenden oberen Kühlkörpern aufweist, die bevorzugt über ein insbesondere zwischen ihnen angeordnetes Kühlkörpergelenk derart gelenkig miteinander verbunden sind, dass die beiden Kühlkörper relativ zueinander in verschiedene, insbesondere parallele Ebenen bewegbar sind, wobei das untere Kühlbauteil und das obere Kühlbauteil über seitlich angeordnete Verbindungsleitungen miteinander verbunden sind.

Durch die Verwendung von zwei untereinander gelenkig verbundenen oberen Kühlkörpern und mithin auch zwei derart verbundenen, an dem jeweiligen zu kühlenden Gegenstand anzuordnenden Wärmeaufnahmeseiten, wird eine Kühleinrichtung geschaffen, bei der insbesondere größere Toleranzen bzw. Abstände zwischen der jeweiligen Wärmeaufnahmeseite und der oder den Wärmeabgabeseiten des oder der zu kühlenden Gegenstände ausgeglichen werden können, die sich andernfalls dadurch ergeben können, dass im Fall von mehreren getrennten Wärmeabgabeseiten diese nicht in einer gemeinsamen Ebene verlaufen, oder dass bezogen auf jeweils eine Wärmeabgabeseite diese einzelne Flächenbereiche aufweist, die in unterschiedlichen Ebenen verlaufen.

Infolgedessen ist es erfindungsgemäß vorteilhafterweise zumindest nicht (mehr) notwendig, zur Überbrückung insbesondere solcher größerer Abstände Wärmeleitpaste großer Schichtdicke verwenden zu müssen, was im Ergebnis im Vergleich zu den Lösungen des Standes der Technik zu einer höheren Kühlleistung der erfindungsgemäßen Kühleinrichtung führt. Es versteht sich, dass aber natürlich auch bei der erfindungsgemäßen Lösung weiterhin Wärmeleitpaste zwischen den vorgenannten Seiten eingesetzt werden kann, insbesondere zum Ausgleich kleinerer Toleranzen, die sich beispielsweise aus der jeweiligen Struktur der ansonsten ebenen Wärmeabgabeseiten ergeben können.

In weiterer Konkretisierung dieses Konzepts kann die Wärmeaufnahmeseite jedes oberen Kühlkörpers, die im Einsatz der Kühleinrichtung an dem jeweils zu kühlenden Gegenstand angeordnet werden soll, jeweils eine insbesondere durch die jeweilige Unterseite des jeweiligen oberen Kühlkörpers gebildete Wärmeaufnahmefläche aufweisen, wobei die Wärmeaufnahmeflächen der einzelnen oberen Kühlkörper relativ zueinander in verschiedene Ebenen bewegbar sind.

Die Wärmeaufnahmefläche des jeweils einen Kühlkörpers kann dann bei der Relativbewegung der oberen Kühlkörper (um die gelenkige Verbindung) naturgemäß relativ zu der Wärmeaufnahmefläche des jeweils anderen oberen Kühlkörpers bewegt werden.

Es versteht sich, dass die Kühleinrichtung auch mehrere Paare von jeweils derart gelenkig miteinander verbundenen oberen Kühlkörpern aufweisen kann.

Beispielsweise könnten mindestens drei obere Kühlkörper bzw. zwei Paare von oberen Kühlkörpern vorgesehen sein, mit einem mittleren oberen Kühlkörper, der unter Bildung eines ersten Paares an einer ersten Seite (des mittleren oberen Kühlkörpers) mit einem ersten äußeren oberen Kühlkörper gelenkig verbunden ist und der unter Bildung eines zweiten Paares an einer zweiten Seite (des mittleren oberen Kühlkörpers) mit einem zweiten äußeren oberen Kühlkörper gelenkig verbunden ist.

Was das oder jedes Kühlkörpergelenk betrifft, so kann dieses zwei voneinander beabstandete, insbesondere parallele Drehachsen aufweisen, um die die mindestens zwei Kühlkörper relativ zueinander in die verschiedenen Ebenen bewegbar, nämlich verschwenkbar, sind.

Erfindungsgemäß weist das oder jedes Kühlkörpergelenk einen flexiblen, insbesondere biegeweichen, bevorzugt plattenförmig ausgebildeten (insbesondere dünnwandigen) Gelenkabschnitt auf, der (insbesondere an zwei Seiten jeweils) entweder einstückig mit den mindestens zwei oberen Kühlkörpern verbunden ist und dabei über eine geringere Materialdicke verfügt als die mindestens zwei oberen Kühlkörper, die der Gelenkabschnitt gelenkig verbindet, oder der (insbesondere an zwei Seiten jeweils) einstückig verbunden ist mit einem Grundkörper, insbesondere aus Kunststoff, der mit den mindestens zwei oberen Kühlkörpern, die der Gelenkabschnitt gelenkig verbindet, insbesondere fluiddicht verbunden ist. Die Flexibilität bzw. Verformbarkeit des Gelenkabschnitts ermöglicht es dabei gerade, die jeweils mit diesem gelenkig verbundenen oberen Kühlkörper in die verschiedenen Ebenen zu bewegen.

So könnten die oberen Kühlkörper mit zunächst in einer gemeinsamen Ebene angeordneten Wärmeaufnahmeflächen beispielsweise auf zu kühlende Gegenstände unterschiedlicher Höhe aufgelegt werden und dann auf die oberen Kühlkörper in Richtung der zu kühlenden Gegenstände Druck aufgebracht werden, sodass sich die Wärmeaufnahmeflächen relativ zueinander bewegen, dabei unter Verformung des Gelenkabschnittes, beispielsweise im Bereich von Rändern desselben, die unterschiedlichen Höhen der zu kühlenden Gegenstände derselben ausgleichen und sich dabei jeweils ohne Abstand an die zu kühlenden Gegenstände anlegen, insbesondere an die jeweilige Wärmeabgabeseite des jeweiligen zu kühlenden Gegenstands.

Weiter kann vorgesehen sein, dass der flexible Gelenkabschnitt an zwei gegenüberliegenden Seiten jeweils angrenzt an einen von zwei Verbindungsabschnitten, mit dem bzw. mit denen der Gelenkabschnitt jeweils einstückig verbunden ist, wobei jeder der beiden Verbindungsabschnitte wiederum mit einem der mindestens zwei oberen Kühlkörper einstückig verbunden ist, wobei die Dicke jedes Verbindungsabschnitts in seinem an den Gelenkabschnitt angrenzenden Bereich der Dicke des Gelenkabschnitts entspricht und wobei dessen Dicke ausgehend davon in Richtung des oberen Kühlkörpers, mit dem er einstückig verbunden ist, insbesondere kontinuierlich ansteigt bis sie der Dicke dieses oberen Kühlkörpers entspricht.

Die beiden oben genannten Drehachsen jedes oberen Kühlkörpers können im Übrigen vorzugsweise im Bereich der gegenüberliegenden Seiten oder an den gegenüberliegenden Seiten des Gelenkabschnitts angeordnet sein, die jeweils an den jeweiligen Verbindungsabschnitt angrenzen.

In einer weiteren bevorzugten Ausführungsform der Erfindung kann die Kühleinrichtung Mittel aufweisen zum Aufbringen von die Relativbewegung der mindestens zwei oberen Kühlkörper in die verschiedenen Ebenen erzeugender, auf den jeweiligen oberen Kühlkörper wirkender Kraft.

Diese Mittel zum Aufbringen der Kraft können eine Spanneinrichtung umfassen, in der die oberen Kühlkörper zwischen einem ersten, insbesondere bewegbaren Spannbauteil und einem zweiten, insbesondere ortsfesten Spannbauteil einspannbar sind. Dies bevorzugt unter jeweiliger Anlage oder Anordnung der oberen Kühlkörper, insbesondere der jeweiligen Wärmeaufnahmefläche des jeweiligen oberen Kühlkörpers, an ein oder mehrere, zwischen den beiden Spannbauteilen anordenbare, zu kühlende Gegenstände.

Vorzugsweise kann das erste Spannbauteil mittels Federkraft gegen die oberen Kühlkörper gedrückt werden. Alternativ oder zusätzlich kann das erste Spannbauteil zum Aufbringen von Federkraft auf die oberen Kühlkörper aus elastischem Material ausgebildet sein.

Weiter kann vorgesehen sein, dass jeder oberer Kühlkörper fest und fluiddicht, insbesondere flüssigkeitsdicht, mit einem oder dem bevorzugt aus Kunststoff gebildeten, gemeinsamen Grundkörper verbunden ist, insbesondere auf der von der jeweiligen Wärmeaufnahmefläche abgewandten Seite des oberen Kühlkörpers, wobei der jeweilige obere Kühlkörper und der Grundkörper gemeinsam den Kühlfluidraum ganz oder teilweise umschließen oder nach außen hin begrenzen.

Weiter kann vorgesehen sein, dass der Kühlfluidraum gebildet ist aus einer Mehrzahl von in die Kühlkörper jeweils eingebrachten, insbesondere in die Kühlkörper eingefrästen Fluidleitungen oder solche Fluidleitungen umfasst.

Weitere Merkmale der vorliegenden Erfindung ergeben sich aus den beigefügten Patentansprüchen, der nachfolgenden Beschreibung bevorzugter Ausführungsbeispiele, sowie aus den beigefügten Zeichnungen.

Darin zeigt:
- Fig. 1:: eine erfindungsgemäße Kühleinrichtung in Schrägansicht mit drei zu kühlenden Gegenständen identischer Höhe,
- Fig. 2:: die Kühleinrichtung aus Fig. 1 in Seitenansicht,
- Fig. 3:: eine erfindungsgemäße Kühleinrichtung in Schrägansicht analog zu der Darstellung in Fig. 2 mit drei zu kühlenden Gegenständen, von denen einer eine größere Höhe aufweist als die anderen beiden,
- Fig. 4:: eine weitere Ausführungsform einer erfindungsgemäßen Kühleinrichtung in einer Seitenansicht analog zu Fig. 2.

Die in den Figuren gezeigte Kühleinrichtung 10 dient zum Abführen von Wärme von zu kühlenden Gegenständen 11, im vorliegenden Fall Leistungselektronikbauteilen (etwa Wechselrichtermodule), wie sie beispielsweise im Zusammenhang mit Batterien bzw. Akkus von Elektrofahrzeugen verwendet werden. Auf die Art der zu kühlenden Gegenstände kommt es erfindungsgemäß allerdings nicht an.

Die Kühleinrichtung 10 verfügt über einen unteren Kühlkörper 12, auf dem die zu kühlenden Gegenstände 11 angeordnet sind bzw. sitzen und der die Unterseiten der zu kühlenden Gegenstände 11 kühlt bzw. Wärme von diesen aufnimmt, sowie über mehrere, vorliegend drei, obere Kühlkörper 20, 21, 22, die jeweils an den Oberseiten der kühlenden Gegenstände 11 anliegen und diese kühlen bzw. Wärme von deren Oberseiten aufnehmen.

Der untere Kühlkörper 12 sowie die oberen Kühlkörper 20, 21, 22 sind vorliegend jeweils als massive Metallkörper ausgebildet, beispielsweise aus Aluminium.

Der untere Kühlkörper 12 ist Teil eines unteren Kühlbauteils 14, das im Inneren (nicht gezeigt) über einen Kühlfluidraum verfügt, der nach außen von dem unteren Kühlkörper 12 und einem beispielsweise aus Kunststoff hergestellten Grundkörper begrenzt wird, wobei der untere Kühlkörper 12 und der ihm zugeordnete Grundkörper fluiddicht, vorliegend flüssigkeitsdicht, miteinander verbunden sind (etwa stoffschlüssig). In den Figuren sind der untere Kühlkörper 12 des unteren Kühlbauteils 14 und dessen Grundkörper der Einfachheit halber zeichnerisch nicht einzeln aufgelöst, sondern vielmehr als Gesamteinheit bzw. Gesamtblock dargestellt.

Die oberen Kühlkörper 20, 21, 22 sind Teil eines oberen Kühlbauteils 15, das ebenfalls im Inneren über einen nicht dargestellten Kühlfluidraum verfügt, der nach außen einerseits von den oberen Kühlkörpern 20, 21, 22 und andererseits von einem beispielsweise ebenfalls aus Kunststoff hergestellten, diesen oberen Kühlkörpern 20, 21, 22 zugeordneten Grundkörper 19 begrenzt wird. Auch die oberen Kühlkörper 20, 21, 22 und der ihnen gemeinsam zugeordnete Grundkörper 19 des oben Kühlbauteils 15 sind dabei fluiddicht, vorliegend ebenfalls flüssigkeitsdicht, miteinander verbunden (etwa stoffschlüssig).

Ein oder beide Kühlfluidräume können beispielsweise aus einer Mehrzahl von in den jeweiligen Kühlkörpern 12 bzw. 20, 21, 22 eingebrachten, insbesondere eingefrästen Fluidleitungen bestehen oder diese umfassen.

Das untere Kühlbauteil 14 und das obere Kühlbauteil 15, genauer gesagt die Kühlfluidräume derselben, sind vorliegend über seitlich angeordnete, insbesondere senkrecht zu ihnen verlaufende Verbindungsleitungen 16 fluidleitend miteinander verbunden.

Die Kühleinrichtung 10 verfügt des Weiteren über einen Mediumeinlass 17 sowie einen Mediumauslass 18.

Im Ergebnis kann entsprechend über den Mediumeinlass 17 zunächst dem unteren Kühlbauteil 14 und in der Folge auch dem oberen Kühlbauteil 15 Kühlfluid zugeführt werden, das im Betrieb der Kühleinrichtung 10 die (Ab-)Wärme abführen kann, die die Kühlkörper 12 bzw. 20, 21, 22 von den zu kühlenden Gegenständen 11 aufnehmen.

In der Regel wird es sich bei dem Kühlfluid um eine Kühlflüssigkeit handeln. Es versteht sich aber, dass es auch im Rahmen der Erfindung liegt, als Kühlfluid ein gasförmiges Medium zu verwenden. Die entsprechenden fluiddichten Verbindungen zwischen dem jeweiligen Grundkörper und dem unteren bzw. oberen Kühlkörper 12 bzw. 20, 21, 22 etc. müssten dann entsprechend gasdicht ausgebildet sein.

Erfindungsgemäß sind die oberen Kühlkörper 20, 21, 22 in besonderer Weise paarweise jeweils gelenkig miteinander verbunden, sodass sie relativ zueinander bewegbar sind. Dabei ist ein erstes Paar aus den oberen Kühlkörpern 20, 21 über ein erstes Kühlkörpergelenk 23 gelenkig miteinander verbunden und ein zweites Paar aus den oberen Kühlkörpern 21, 22 durch ein zweites Kühlkörpergelenk 24.

Jeder obere Kühlkörper 20, 21, 22 verfügt jeweils über eine ebene Unterseite, die eine (äußere) ebene bzw. plane Wärmeaufnahmefläche 25 bildet, die im Betrieb der Kühleinrichtung 10 an einer gegenüberliegenden, vorliegend ebenfalls ebenen, durch deren jeweilige Oberseite gebildete Wärmeabgabefläche 26 des jeweiligen zu kühlenden Gegenstands 11 anliegt bzw. dieser parallel gegenüberliegt, wobei ggf. zwischen der Wärmeaufnahmefläche 25 und der Wärmeabgabefläche 26 noch Wärmeleitpaste angeordnet sein kann, die unter anderem geringfügige Unebenheiten der Flächen 25 und/oder 26 ausgleicht und so eine optimale Wärmeleitung zwischen diesen Flächen herstellt.

Die gelenkigen Verbindungen der oberen Kühlkörper 20, 21, 22 ermöglichen bei Anlage bzw. Anordnung des jeweiligen oberen Kühlkörpers 20, 21, 22 an die zu kühlenden Gegenstände 11 einen besonderen Toleranzausgleich, wie nachfolgend näher ausgeführt wird.

Konkret können hierdurch beispielsweise auch etwas größere Unterschiede in den Höhenabmessungen der einzelnen zu kühlenden Gegenstände 11 ausgeglichen werden, deren Ausgleich etwa mittels Wärmeleitpaste aufgrund der hierfür notwendigen Schichtdicken mit Blick auf eine möglichst optimierte Wärmeleitung (zu) nachteilig wäre.

In einem solchen Fall größerer Höhenunterschiede (aber auch in anderen sinnvollen Fällen) können dann die einzelnen, ebenen Wärmeaufnahmeflächen 25 der jeweiligen oberen Kühlkörper 20, 21, 22 in verschiedene Ebenen bewegt werden, sodass sie dann trotz nicht in einer gemeinsamen Ebene verlaufender Wärmeabgabeflächen 26 der zu kühlenden Gegenstände 11 dennoch jeweils ohne oder nur mit geringstmöglichem Abstand der ihnen jeweils zugeordneten (ebenen) Wärmeabgabefläche 26 des jeweiligen zu kühlenden Gegenstands 11 unmittelbar gegenüberliegen.

Die hierfür notwendige Beweglichkeit zwischen den einzelnen oberen Kühlkörpern 20, 21, 22 wird, wie oben bereits angedeutet, durch die Kühlkörpergelenke 23 bzw. 24 ermöglicht.

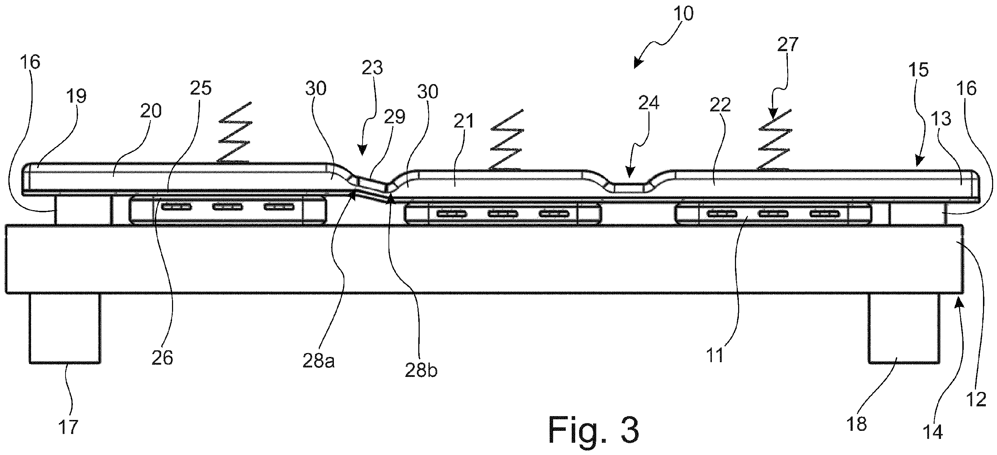

Zur weiteren Verdeutlichung ist in Fig. 3 eine Situation gezeigt, in der einer der zu kühlenden Gegenstände 11, nämlich der linke äußere zu kühlende Gegenstand 11, eine größere Höhe aufweist als die anderen beiden zu kühlenden Gegenstände 11. Entsprechend verläuft dessen Wärmeabgabefläche 26 in einer anderen (höheren) Ebene als die Wärmeabgabeflächen 26 der anderen beiden zu kühlenden Gegenstände 11.

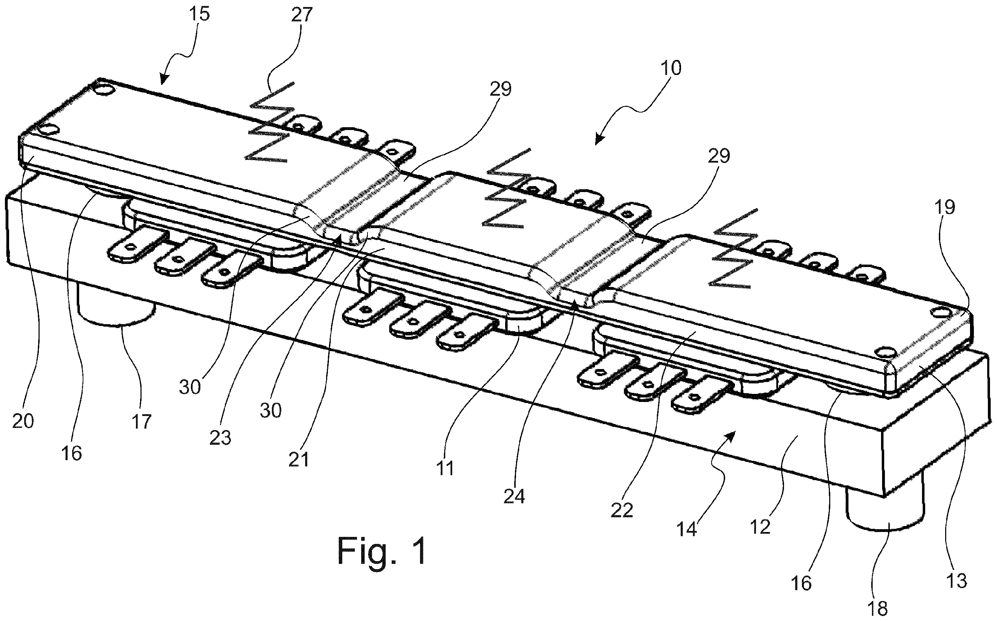

Um dies auszugleichen, wurde das obere Kühlbauteil 15 im Vergleich zur Situation der Fig. 1, in der sämtliche Wärmeaufnahmeflächen 25 des oberen Kühlbauteils 15 bzw. der oberen Kühlkörper 20, 21, 22 in einer gemeinsamen Ebene liegen, durch Aufbringen von Druck auf das obere Kühlbauteil 15 bzw. mittelbar auf die oberen Kühlkörper 20, 21, 22 verformt. Schematisch angedeutet sind Kräfte 27, die von oben auf das obere Kühlbauteil 15 bzw. entsprechend auf die oberen Kühlkörper 20, 21, 22 einwirken, um diese Verformung zu bewirken.

Konkret wirken diese Kräfte 27 auf die einzelnen oberen Kühlkörper 20, 21, 22 ein und sorgen insbesondere für eine Relativbewegung zwischen dem äußeren oberen Kühlkörper 20 und dem benachbarten, mittleren oberen Kühlkörper 21.

Zu diesem Zweck umfassen das erste und das zweite Kühlkörpergelenk 23 bzw. 24 jeweils einen mit den oberen Kühlkörper 20, 21, 22 einstückig verbundenen, beispielsweise plattenförmigen Gelenkabschnitt 29. Dieser verfügt über eine deutlich geringe Materialdicke als die beiden oberen Kühlkörper 20, 21 bzw. 21, 22, die das jeweilige Kühlkörpergelenk 23 bzw. 24 gelenkig miteinander verbindet.

Dabei ist die (geringere) Materialdicke derart gewählt, dass der jeweilige Gelenkabschnitt 29 insgesamt flexibel (verformbar) bzw. biegeweich ist. Im Bereich von gegenüberliegenden Seiten des jeweiligen Gelenkabschnitts 29 bilden sich dabei jeweils definierte, voneinander beabstandete, parallele Drehachsen 28a bzw. 28b aus, die vorliegend parallel zu der Ebene der jeweiligen Wärmeaufnahmefläche 25 verlaufen, und um die die Kühlkörper 20, 21, 22 jeweils (durch Verformung des Gelenkabschnitts 29 in diesem Bereich) drehbar sind.

Im Bereich beider gegenüberliegender Seiten des jeweiligen Gelenkabschnitts 29 grenzt dieser im Übrigen jeweils an einen mit den beiden oberen Kühlkörpern 20, 21 bzw. 21, 22 eines Paares benachbarter Kühlkörper 20, 21, 22 einstückig verbundenen Verbindungsabschnitt 30 an, dessen Dicke in seinem an den Gelenkabschnitt 29 angrenzenden Bereich der Dicke des Gelenkabschnitts 29 entspricht und dessen Dicke ausgehend davon in Richtung des jeweiligen Kühlkörpers 20, 21 bzw. 22 insbesondere kontinuierlich ansteigt bis sie der Dicke des Kühlkörpers 20, 21 bzw. 22 entspricht.

Was die oben genannte Relativbewegung zwischen dem äußeren oberen Kühlkörper 20 und dem benachbarten, mittleren oberen Kühlkörper 21 betrifft, so ermöglicht sie eine entsprechende Ausrichtung bzw. Bewegung der einzelnen Kühlkörper 20 und 21 derart, dass anschließend sowohl die Wärmeaufnahmefläche 25 des äußeren oberen Kühlkörpers 20 als auch die Wärmeaufnahmefläche 25 des mittleren oberen Kühlkörpers 21 jeweils an der ihnen zugeordneten Wärmeabgabefläche 26 des jeweiligen zu kühlenden Gegenstands 11 anliegen (Fig. 3).

Die vorgenannten Kräfte 27 werden im vorliegenden Beispiel von einer nicht dargestellten Spanneinrichtung aufgebracht, in der das untere und das obere Kühlbauteil 14 bzw. 15 zusammen mit den zwischen ihnen angeordneten zu kühlenden Gegenständen 11 zwischen einem ersten, insbesondere bewegbaren, vorzugsweise als Feder ausgebildeten Spannbauteil und einem zweiten, insbesondere ortsfesten Spannbauteil eingespannt ist.

Dabei kann im Übrigen auch vorgesehen sein, dass beispielsweise das untere Kühlbauteil 15 gleichzeitig das zweite, ortsfeste Spannbauteil bildet.

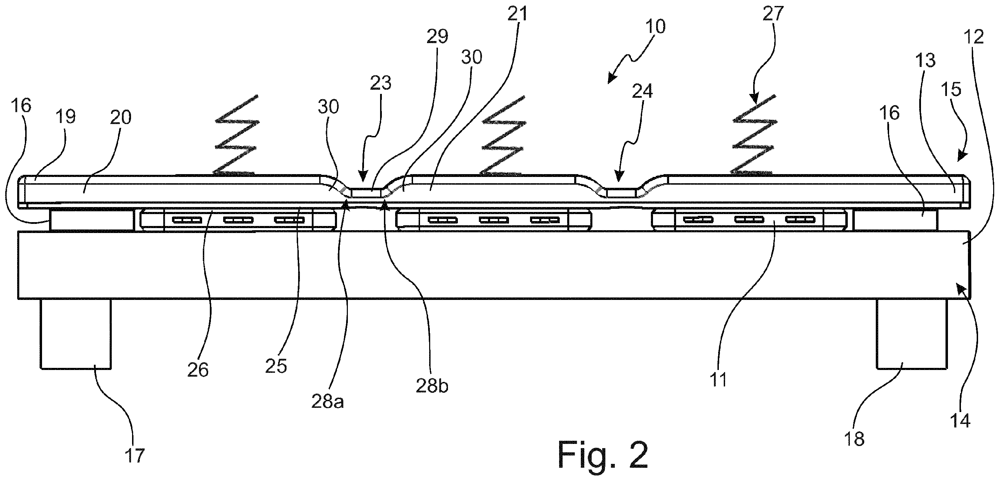

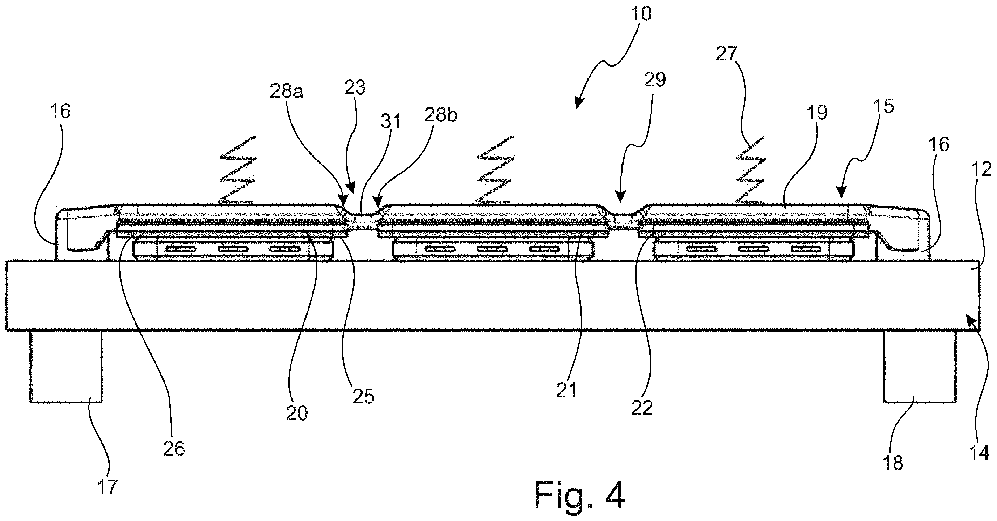

In Fig. 4 ist eine Ausführungsform einer erfindungsgemäßen Kühleinrichtung 10 gezeigt, in der die einzelnen Kühlkörper 20, 21, 22 in anderer Weise als in den Fig. 1-3 miteinander gelenkig verbunden sind. Nämlich nicht unmittelbar über einen einstückig mit ihnen verbundenen Gelenkabschnitt 29 bzw. Verbindungsabschnitt 30, sondern nur mittelbar über einen flexiblen, zwischen den Paaren von Kühlkörpern 20, 21 bzw. 21, 22 angeordneten Gelenkabschnitt 31, der in diesem Fall Teil des mit den oberen Kühlkörpern 20, 21, 22 (fluiddicht) verbundenen Grundkörpers 19 aus Kunststoff ist bzw. einstückig mit diesem verbunden ist.

Die oberen Kühlkörper 20, 21, 22 sind in diesem Fall insofern materialbezogen separate bzw. separat hergestellte Bauteile, die (nur) durch den gemeinsamen Grundkörper 19 miteinander verbunden wurden bzw. sind, während sie in der Ausführungsform der Fig. 1-3 aus einem gemeinsamen Material- bzw. Metallblock hergestellt sind, in den durch geeignete Bearbeitung des Materialblocks die Verbindungabschnitte 30 bzw. die Gelenkabschnitte 29 eingearbeitet wurden bzw. sind,
sodass die oberen Kühlkörper 20, 21, 22 im Ergebnis entsprechend einstückig miteinander verbunden sind.

### Bezugszeichenliste

10 Kühleinrichtung
11 zu kühlender Gegenstand
12 unterer Kühlkörper
14 unteres Kühlbauteil
15 oberes Kühlbauteil
16 Verbindungsleitung
17 Mediumeinlass
18 Mediumauslass
19 Grundkörper oberes Kühlbauteil
20 äußerer oberer Kühlkörper
21 mittlerer oberer Kühlkörper
22 äußerer oberer Kühlkörper
23 erstes Kühlkörpergelenk
24 zweites Kühlkörpergelenk
25 Wärmeaufnahmefläche
26 Wärmeabgabefläche
27 Kraft
28a Drehachse
28b Drehachse
29 Gelenkabschnitt
30 Verbindungsabschnitt
31 Gelenkabschnitt

## Patentansprüche

1. Kühleinrichtung zum Abführen von Wärme von zu kühlenden Gegenständen, wie etwa von Leistungselektronikmodulen, mit einem unteren Kühlbauteil (14) mit einem unteren Kühlkörper (12) und einem oberen Kühlbauteil (15) mit mindestens zwei oberen Kühlkörpern (20, 21, 22), bevorzugt aus Metall, wie etwa aus Aluminium, zur Aufnahme von Wärme eines oder mehrerer zu kühlender Gegenstände, wobei das untere und das obere Kühlbauteil (14, 15) einen Kühlfluidraum zur Aufnahme von Kühlfluid, insbesondere Kühlflüssigkeit, an das die von dem jeweiligen Kühlkörper (12, 20, 21, 22) aufgenommene Wärme weiterleitbar ist, aufweisen, wobei die mindestens zwei oberen Kühlkörper (20, 21, 22) über ein Kühlkörpergelenk (23, 24) derart gelenkig miteinander verbunden sind, dass die mindestens zwei oberen Kühlkörper (20, 21, 22) relativ zueinander in verschiedene, insbesondere parallele Ebenen bewegbar sind, wobei das Kühlkörpergelenk (23, 24) einen flexiblen, insbesondere biegeweichen, bevorzugt plattenförmig ausgebildeten Gelenkabschnitt aufweist, der entweder einstückig mit den mindestens zwei oberen Kühlkörpern (20, 21, 22) verbunden ist und dabei über eine geringere Materialdicke verfügt als die mindestens zwei oberen Kühlkörper (20, 21, 22), oder der einstückig verbunden ist mit einem Grundkörper, der mit den mindestens zwei oberen Kühlkörpern (20, 21, 22) insbesondere fluiddicht verbunden ist, und wobei das untere Kühlbauteil (14) und das obere Kühlbauteil (15) über seitlich angeordnete Verbindungsleitungen (16) miteinander verbunden sind.

2. Kühleinrichtung gemäß Anspruch 1, **dadurch gekennzeichnet, dass** das Kühlkörpergelenk (23, 24) zwei voneinander beabstandete, insbesondere parallele Drehachsen aufweist, um die die beiden Kühlkörper (20, 21, 22) relativ zueinander in die verschiedenen Ebenen bewegbar, nämlich verschwenkbar sind.

3. Kühleinrichtung gemäß einem oder mehreren der vorhergehenden Ansprüche 1 und 2, **dadurch gekennzeichnet, dass** der flexible Gelenkabschnitt an zwei gegenüberliegenden Seiten jeweils angrenzt an einen von zwei Verbindungsabschnitten, mit dem er einstückig verbunden ist, wobei jeder der beiden Verbindungsabschnitte wiederum mit einem der mindestens zwei Kühlkörper (20, 21, 22) einstückig verbunden ist, und wobei die Dicke jedes Verbindungsabschnitts in seinem an den Gelenkabschnitt angrenzenden Bereich der Dicke des Gelenkabschnitts entspricht und wobei dessen Dicke ausgehend davon in Richtung des Kühlkörpers (20, 21, 22), mit dem er einstückig verbunden ist, insbesondere kontinuierlich ansteigt, bis sie der Dicke dieses Kühlkörpers (20, 21, 22) entspricht.

4. Kühleinrichtung gemäß einem oder mehreren der vorhergehenden Ansprüche 2 und 3, **dadurch gekennzeichnet, dass** die beiden Drehachsen des Kühlkörpergelenks (23, 24) im Bereich der gegenüberliegenden Seiten des Gelenkabschnitts angeordnet sind, die jeweils an den jeweiligen Verbindungsabschnitt angrenzen, oder an diesen Seiten.

5. Kühleinrichtung gemäß einem oder mehreren der vorhergehenden Ansprüche, **dadurch gekennzeichnet, dass** die Kühleinrichtung Mittel aufweist zum Aufbringen von die Relativbewegung der mindestens zwei oberen Kühlkörper (20, 21, 22) in die verschiedenen Ebenen erzeugender, auf den jeweiligen oberen Kühlkörper (20, 21, 22) wirkender Kraft.

6. Kühleinrichtung gemäß Anspruch 5, **dadurch gekennzeichnet, dass** die Mittel zum Aufbringen der Kraft eine Spanneinrichtung umfassen, in der die oberen Kühlkörper (20, 21, 22) zwischen einem ersten, insbesondere bewegbaren Spannbauteil und einem zweiten, insbesondere ortsfesten Spannbauteil einspannbar sind, bevorzugt unter jeweiliger Anlage oder Anordnung der oberen Kühlkörper (20, 21, 22), insbesondere von Wärmeaufnahmeflächen derselben, an ein oder mehrere, zwischen den beiden Spannbauteilen anordenbare, zu kühlende Gegenstände.

7. Kühleinrichtung gemäß Anspruch 6, **dadurch gekennzeichnet, dass** das erste Spannbauteil mittels Federkraft gegen die oberen Kühlkörper (20, 21, 22) gedrückt wird, und/oder dass das erste Spannbauteil zum Aufbringen von Federkraft auf die oberen Kühlkörper (20, 21, 22) aus elastischem Material ausgebildet ist.

8. Kühleinrichtung gemäß einem oder mehreren der vorhergehenden Ansprüche, **dadurch gekennzeichnet, dass** jeder der mindestens zwei oberen Kühlkörper (20, 21, 22) eine ebene Wärmeaufnahmefläche zur Anlage oder Anordnung an den jeweiligen zu kühlenden Gegenstand aufweist, und dass jeder der oberen Kühlkörper (20, 21, 22) derart in die verschiedenen Ebenen bewegbar sind, insbesondere über das Kühlkörpergelenk (23, 24), dass deren ebenen Wärmeaufnahmeflächen in verschiedenen, insbesondere parallel mit Abstand zueinander verlaufende Ebenen anordenbar sind.

9. Kühleinrichtung gemäß einem oder mehreren der vorhergehenden Ansprüche, **dadurch gekennzeichnet, dass** jeder der oberen Kühlkörper (20, 21, 22) fest und fluiddicht, insbesondere flüssigkeitsdicht, mit einem oder dem insbesondere gemeinsamen, bevorzugt aus Kunststoff gebildeten Grundkörper verbunden ist, insbesondere auf der von der jeweiligen Wärmeaufnahmefläche abgewandten Seite des jeweiligen oberen Kühlkörpers (20, 21, 22), wobei der jeweilige obere Kühlkörper (20, 21, 22) und der Grundkörper gemeinsam den Kühlfluidraum ganz oder teilweise umschließen oder nach außen hin begrenzen.

10. Kühleinrichtung gemäß Anspruch 9, **dadurch gekennzeichnet, dass** der Kühlfluidraum gebildet ist aus einer Mehrzahl von in die oberen Kühlkörper (20, 21, 22) jeweils eingebrachten Fluidleitungen oder solche in die oberen Kühlkörper (20, 21, 22) eingebrachten Fluidleitungen umfasst.

11. Kühleinrichtung gemäß einem oder mehreren der vorhergehenden Ansprüche, **dadurch gekennzeichnet, dass** die Kühleinrichtung über mehrere Paare von jeweils zwei vorzugsweise starren, jeweils insbesondere über ein Kühlkörpergelenk (23, 24) derart gelenkig miteinander verbundenen oberen Kühlkörpern (20, 21, 22) verfügt, dass sie relativ zueinander in verschiedene, insbesondere parallele Ebenen bewegbar sind.

## Claims

1. A cooling device for dissipating heat from objects to be cooled, such as power electronic modules, with a lower cooling component (14) with a lower heat sink (12) and an upper cooling component (15) with at least two upper heat sinks (20, 21, 22), preferably made out of metal, e.g., aluminum, for absorbing heat of one or several objects to be cooled, wherein the lower and the upper cooling components (14, 15) have a cooling fluid space for holding cooling fluid, in particular cooling liquid, to which the heat absorbed by the respective heat sink (12, 20, 21, 22) can be relayed, wherein the at least two upper heat sinks (20, 21, 22) are jointly interconnected via a heat sink joint (23, 24) in such a way that the at least two upper heat sinks (20, 21, 22) can be moved relative to each other in different, in particular parallel, planes, wherein the heat sink joint (23, 24) has a flexible, in particular pliable, joint section preferably designed like a plate, which is either connected in one piece with the at least two upper heat sinks (20, 21, 22), and in the process has a smaller material thickness than the at least two upper heat sinks (20, 21, 22), or which is connected in one piece with a base body that is connected, in particular fluid-tight, with the at least two upper heat sinks (20, 21, 22), and wherein the lower cooling component (14) and the upper cooling component (15) are connected with each other via laterally arranged connecting lines (16).

2. The cooling device according to claim 1, **characterized in that** the heat sink joint (23, 24) has two spaced apart, in particular parallel, axes of rotation, around which the two heat sinks (20, 21, 22) can be moved, specifically pivoted, relative to each other in the different planes.

3. The cooling device according to one or several of the preceding claims 1 and 2, **characterized in that** the flexible joint section on two opposing sides adjoins one of two connecting sections with which it is connected in one piece, wherein each of the two connecting sections is in turn connected in one piece with one of the at least two heat sinks (20, 21, 22), and wherein the thickness of each connecting piece in its area adjacent to the joint section corresponds to the thickness of the joint section, and wherein its thickness rises proceeding from there in the direction of the heat sink (20, 21, 22) with which it is connected in one piece, in particular continuously, until it corresponds to the thickness of this heat sink (20, 21, 22).

4. The cooling device according to one or several of the preceding claims 2 and 3, **characterized in that** the two axes of rotation of the heat sink joint (23, 24) are arranged in the area of the opposing sides of the joint section that each adjoin the respective connecting section, or these sides.

5. The cooling device according to one or several of the preceding claims, **characterized in that** the cooling device has means for applying the force that generates the relative movement of the at least two upper heat sinks (20, 21, 22) in the different planes and acts on the respective upper heat sink (20, 21, 22).

6. The cooling device according to claim 5, **characterized in that** the means for applying the force comprise a clamping device, in which the upper heat sinks (20, 21, 22) can be clamped between a first, in particular movable, clamping component and a second, in particular stationary, clamping component, preferably while correspondingly resting or arranging the upper heat sinks (20, 21, 22), in particular the heat absorbing surfaces thereof, against one or several objects to be cooled, which can be arranged between the two clamping components.

7. The cooling device according to claim 6, **characterized in that** the first clamping component is pressed by a spring force against the upper heat sinks (20, 21, 22), and/or that the first clamping component for applying spring force to the upper heat sink (20, 21, 22) is made out of elastic material.

8. The cooling device according to one or several of the preceding claims, **characterized in that** each of the at least two upper heat sinks (20, 21, 22) has a flat heat absorbing surface to rest or arrange against the respective object to be cooled, and that each of the upper heat sinks (20, 21, 22) can be moved in the different planes, in particular via the heat sink joint (23, 24), in such a way that their flat heat absorbing surfaces can be arranged in different planes, which in particular run spaced apart and parallel to each other.

9. The cooling device according to one or several of the preceding claims, **characterized in that** each of the upper heat sinks (20, 21, 22) is rigidly and fluid tightly, in particular liquid tightly, connected with one or the in particular shared base body, preferably made out of plastic, in particular on the side of the respective upper heat sink (20, 21, 22) facing away from the respective heat absorbing surface, wherein the respective upper heat sink (20, 21, 22) and the base body together completely or partially envelop the cooling fluid space, or outwardly border it.

10. The cooling device according to claim 9, **characterized in that** the cooling fluid space consists of a plurality of fluid lines respectively integrated into the upper heat sinks (20, 21, 22) or comprises such fluid lines integrated into the upper heat sinks (20, 21, 22).

11. The cooling device according to one or several of the preceding claims, **characterized in that** the cooling device has several pairs of a respective two preferably rigid upper heat sinks (20, 21, 22) each jointly connected with each other in particular via a heat sink joint (23, 24) in such a way that they can be moved relative to each other in different, in particular parallel planes.

## Revendications

1. Système de refroidissement pour évacuer de la chaleur d'objets à refroidir, comme par exemple des modules électroniques de puissance, avec un composant de refroidissement inférieur (14) avec un corps de refroidissement inférieur (12) et un composant de refroidissement supérieur (15) avec au moins deux corps de refroidissement supérieurs (20, 21, 22), de préférence en métal, comme par exemple de l'aluminium, pour réceptionner de la chaleur d'un ou plusieurs objets à refroidir, sachant que le composant de refroidissement inférieur et le composant de refroidissement supérieur (14, 15) comportent un compartiment de fluide de refroidissement pour recevoir du fluide de refroidissement, en particulier un liquide réfrigérant, auquel la chaleur réceptionnée du corps de refroidissement respectif (12, 20, 21, 22) peut être transmise, sachant qu'au moins les deux corps de refroidissement supérieurs (20, 21, 22) sont reliés entre eux de façon articulée par une articulation de corps de refroidissement (23, 24) de telle manière qu'au moins les deux corps de refroidissement supérieurs (20, 21, 22) peuvent être mobiles l'un par rapport à l'autre dans des plans différents, en particulier parallèles, sachant que l'articulation de corps de refroidissement (23, 24) comporte une section d'articulation flexible, en particulier souple, constituée de préférence en forme de plaque, qui est reliée soit en une pièce à au moins les deux corps de refroidissement supérieurs (20, 21, 22) et dispose à cet effet d'une épaisseur de matériau plus faible qu'au moins les deux corps de refroidissement supérieurs (20, 21, 22), soit qui est reliée en une pièce avec un corps de base qui est relié à au moins les deux corps de refroidissement supérieurs (20, 21, 22), en particulier de façon étanche au fluide et sachant que le composant de refroidissement inférieur (14) et le composant de refroidissement supérieur (15) sont reliés l'un à l'autre par des conduites de liaison (16) disposées latéralement.

2. Système de refroidissement selon la revendication 1, **caractérisé en ce que** l'articulation de corps de refroidissement (23, 24) comporte deux axes de rotation à distance l'un de l'autre, en particulier parallèles autour desquels les deux corps de refroidissement (20, 21, 22) peuvent être mobiles, à savoir peuvent pivoter, l'un par rapport à l'autre, dans les différents plans.

3. Système de refroidissement selon l'une quelconque ou plusieurs des revendications précédentes 1 et 2, **caractérisé en ce que** la section d'articulation flexible aux deux côtés opposés vient toucher respectivement à une des deux sections de liaison à laquelle elle est relié en une pièce, sachant que chacune des deux sections de liaison est reliée en une pièce à nouveau au moins à au moins un des deux corps de refroidissement (20, 21, 22) et sachant que l'épaisseur de chaque section de liaison correspond dans sa zone avoisinant la section d'articulation à l'épaisseur de la section d'articulation et sachant que l'épaisseur de celle-ci en partant de celle-ci en direction du corps de refroidissement (20, 21, 22) à laquelle elle est reliée en une pièce, augmente en particulier de façon continue jusqu'à ce qu'elle corresponde à l'épaisseur de ce corps de refroidissement (20, 21, 22).

4. Système de refroidissement selon l'une quelconque ou plusieurs des revendications précédentes 2 et 3, **caractérisé en ce que** les deux axes de rotation de l'articulation de corps de refroidissement (23, 24) sont disposés dans la zone des côtés opposés de la section d'articulation, qui viennent toucher respectivement la section de liaison respective, ou sur ces côtés.

5. Système de refroidissement selon l'une quelconque des revendications précédentes, **caractérisé en ce que** le système de refroidissement comporte des moyens pour l'application d'une force générant le mouvement relatif d'au moins les deux corps de refroidissement supérieurs (20, 21, 22) dans les différents plans, agissant sur le corps de refroidissement supérieur (20, 21, 22) respectif.

6. Système de refroidissement selon la revendication 5, **caractérisé en ce que** les moyens d'application de la force comprennent un système de serrage dans lequel les corps de refroidissement supérieurs (20, 21, 22) peuvent être serrés entre un premier composant de serrage, en particulier mobile et un deuxième composant de serrage en particulier fixe, de préférence avec l'installation ou la mise en place respective des corps de refroidissement supérieurs (20, 21, 22), en particulier des surfaces de réception de chaleur de ceux-ci, sur un ou plusieurs des objets à refroidir pouvant être disposés entre les deux composants de serrage.

7. Système de refroidissement selon la revendication 6, **caractérisé en ce que** le premier composant de serrage est appuyé au moyen d'une force élastique contre le corps de refroidissement supérieur (20, 21, 22) et/ou **en ce que** le premier composant de serrage est constitué d'un matériau élastique pour l'application d'une force élastique aux corps de refroidissement supérieur (20, 21, 22).

8. Système de refroidissement selon l'une ou plusieurs des revendications précédentes, **caractérisé en ce que** chacun au moins des deux corps de refroidissement supérieurs (20, 21, 22) comporte une surface de réception de chaleur plane pour l'installation ou la mise en place sur l'objet à refroidir respectif et **en ce que** chacun des corps de refroidissement supérieurs (20, 21, 22) peuvent être mobiles dans les différents plans, en particulier par le biais de l'articulation de corps de refroidissement (23, 24), de telle manière que leurs surfaces de réception de chaleur planes peuvent être disposées dans différents plans, en particulier passant parallèlement à distance l'un de l'autre.

9. Système de refroidissement selon l'une ou plusieurs des revendications précédentes, **caractérisé en ce que** chacun des corps de refroidissement supérieurs (20, 21, 22) est fermement et de façon étanche au fluide, en particulier étanche au liquide, relié à un ou au corps de base en particulier commun, formé de préférence en matière plastique, en particulier sur le côté éloigné de la surface de réception de chaleur respective du corps de refroidissement supérieur (20, 21, 22) respectif, sachant que le corps de refroidissement supérieur respectif (20, 21, 22) et le corps de base entourent ensemble entièrement ou en partie le compartiment de fluide de refroidissement ou le limitent vers l'extérieur.

10. Système de refroidissement selon la revendication 9, **caractérisé en ce que** le compartiment de fluide de refroidissement est formé d'une pluralité de conduites de fluide respectivement incorporées dans les corps de refroidissement supérieur (20, 21, 22) ou comprend de tels éléments incorporés dans les corps de refroidissement supérieur (20, 21, 22).

11. Système de refroidissement selon l'une ou plusieurs des revendications précédentes, **caractérisé en ce que** le système de refroidissement dispose de plusieurs paires de respectivement deux corps de refroidissement supérieurs (20, 21, 22) de préférence rigides, reliés entre eux respectivement de façon articulée en particulier par une articulation de corps de refroidissement (23, 24) de telle manière qu'ils peuvent être mobiles l'un par rapport à l'autre dans différents plans, en particulier parallèles.
